# EUROPEAN PATENT APPLICATION

(11) **EP 1 659 627 A1**
(43) Date of publication of application: **24.05.2006**
(21) Application number: 04027763.4
(22) Date of filing: 23.11.2004
(51) Int. Cl.: H01L 23/495, H01L 23/31

(54) **chip scale package**

(71) Applicant: OPTIMUM CARE INTERNATIONAL TECH INC., Neihu District, Taipei City 114 (TW)
(72) Inventor: Lien, Jeffrey, Shihlin District, Taipei City 111 (TW)
(74) Representative: Appelt, Christian W.

(57) **Abstract**

A miniaturized chip scale package is provided for the improvement of conventional chip package issues such as bulky packaged volume and bad heat dissipation. This invention provides a leadframe comprising multiple block leads for semiconductor die attachment. Conducting metallic wires are used to connect all the block leads of the leadframe to the chip, then the metallic conducting wire part is specifically encapsulated with insulating material to further form a miniaturized encapsulated body. The encapsulated body fully enclose the wire bonding part and at least an out-connecting electrical conducting part is preserved on the lower part of the lead such that the final packaged volume is reduced, heat dissipation efficiency is enhanced, and the chip transfer speed to the outside is enhanced due to a reduction in the transfer distance by the rectangular block leads structure design.

## Description

### BACKGROUND OF THE INVENTION

### 1.Field of the Invention:

This invention is related to a miniaturized chip scale package structure, more specifically related to a chip scale package structure which can greatly reduce its packaged volume, enhance package heat dissipation and transfer speed as well as reducing packaging cost.

### 2.Description of the Related Art:

Transistors used nowadays are required to process or store continuous massive amount of data and perform in multi-function way, for example, several programs are executed in the same time in a single computer which in turn easily causes transistors overheat and system instability. The newly developed DDRII chip has the issue of overheat during operation too, therefore, considering the heat dissipation performance in transistors is always a key issue in developing high level transistors. Furthermore, the electronic and information related products nowadays have been requested to be designed in a miniaturized and multi-function way to comply with portable and versatile requirements from customers, this not only limit the available space in printed circuit board, but also electronic components like transistors have to be reduced in packaged volume correspondingly.

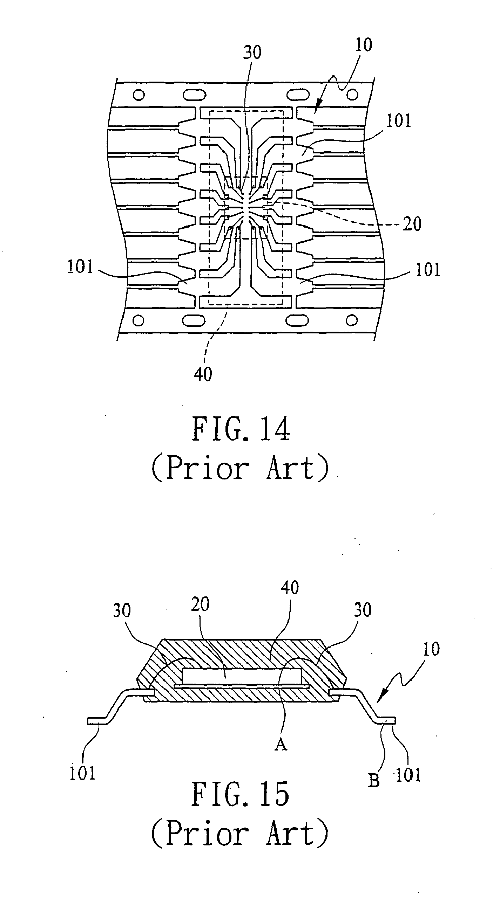

The conventional chip package structure, please refer to figure 14 and figure 15, comprising of electrically out-connecting leadframe 10 which further comprising of multiple piece-like leads 101 and a chip carrier 20, furthermore, the bonding pads in chip 20 are connected to leads 101 of leadframe 10 through bonding wires 30, chip 20 can thus be electrically connected to outside (such as printed circuit board, etc.) through leadframe 10. Moreover, chip 20 and leadframe 10 are encapsulated by insulating material such as plastic or ceramic material such that hermetic seal encapsulated body 40 is formed. We thus know from the prior art that the conventional chip package is bulky since the whole chip and leadframe need to be fully enclosed in the encapsulated body 40; if we try to save the material cost by using cheap encapsulant material, it will affect the heat dissipating efficiency of chip 20, on the other hand, if we adopt expensive encapsulant material, the overall packaging cost will stay high, therefore there is a tradeoff between package structure and production cost; furthermore, a long piece-like and curved lead 101 of leadframe 10 is used as an out-connecting part of chip 20 in the prior art, this is as shown in figure 15, therefore the receiving point A of lead 101 has a very long distance to the connection point B on the printed circuit board, and the signal transfer speed is thus slow which cannot meet the strict requirement from high level transistor device.

### SUMMARY OF THE INVENTION

The main purpose of this invention is to provide a miniaturized package structure and design through the improvement of block leads structure on the leadframe in conjunction with the miniaturization of encapsulated body on the wire-bonding part of the chip, the multiple goals such as packaging cost reduction, chip heat dissipation efficiency enhancement and chip packaged volume reduction, etc. are thus achieved.

According to the above goals, this- invention- is to provide a leadframe structure containing multiple rectangular block leads for at least one chip to be attached to its upper surface, between the lower part of al1 the leads of the leadframe and the chip are connected with conducting metallic wires, then the metallic conducting wire parts are specifically encapsulated with insulating material to further form a miniaturized encapsulated body. The encapsulated body fully encloses the wire bonding part and at least an out-connecting electrical conducting part is preserved on the lower part of the lead such that the chip packaged volume is reduced, heat dissipation efficiency is enhanced, and the chip transfer efficiency to the outside is enhanced due to a reduction in the transfer distance by the rectangular block leads structure design.

### BRIEF DESCRIPTIONS OF THE DRAWINGS

Figure 1 is part of the encapsulated body in cross section illustration for this invention.
Figure 2 is part of the encapsulated body package in bottom view illustration for this invention.
Figure 3 shows encapsulated body inconjunction with electrical connecting part such as solder balls for this invention.
Figure 4 shows another embodiment for this invention with electrical connecting part such as solder balls.
Figure 5 shows the use of solidified metallic solution to replace metallic conducting wire as an electrically conducting connecting part for this invention, it also shows the partly packaged body.
Figure 6 is an embodiment of the current invention which shows a protruding part on the bottom of leads, it also shows the locally packaged body.
Figure 7 shows another embodiment of the current invention which has additional encapsulated body on the peripheral of the chip.
Figure 8 is a cross section view illustration showing each row of leads are separately and partly packaged for another embodiment of the current invention.
Figure 9 is a bottom view illustration showing each row of leads is separately and partly packaged for another embodiment of the current invention.
Figure 10 is a bottom view illustration for the current invention showing each single lead is packaged separately in a point-like manner.
Figure 11 is a bottom view illustration showing each row of leads is separately and locally packaged for further embodiment of the current invention.
Figure 12 shows a packaged structure with 4 rows of leads for the current invention.
Figure 13 shows an assembly composing of leadframe and electrical board for the current invention.
Figure 14 shows the bottom view of a prior art packaged structure with chip and leadframe.
Figure 15 shows the cross section view of a prior is packaged structure with chip and leadframe.

### DETAILED DESCRIPTION OF THE PREFERRED EMBODIMENT

The package structure of the current invention and its purposes are described in detail in the followings by referring to the attached embodiment figures:

As shown in the attached figure, this invention is a "miniaturized chip scale package structure" design, it is a leadframe leads and package structure improvement invention which can achieves multiple purposes in the same time such as: the chip packaged volume reduction, heat dissipation efficiency enhancement and transfer speed enhancement, it can also simplify packaging procedures and reduce material cost, it comprising at least a leadframe 1, chip 2, metallic conducting wire 3 and specifically designed encapsulated 4, wherein:

Leadframe 1 is a chip out-connecting component comprising multiple rows metallic leads 11, the row leads 11 can be setup to be 2 rows or 4 rows or other number of rows and in any locations in accordance with the requirements from chip 2, but all leads 11 are specifically formed to be rectangular block shape and comprising an upper surface 111 which can carry a chip and a lower surface 112 which can be wire bonded and be used as an electrically out-connecting part; chip 2 is a diced chip which containing silicon, gallium arsenide or other semiconductor materials which can be functioned as transistors according to requirements;

Metallic conducting wire 3 is used to connect chip 2 and all the leads 11 of leadframe 1 such that chip 2 can be electrically connected to the outside, the commonly seen gold wire can be selected for this purpose;

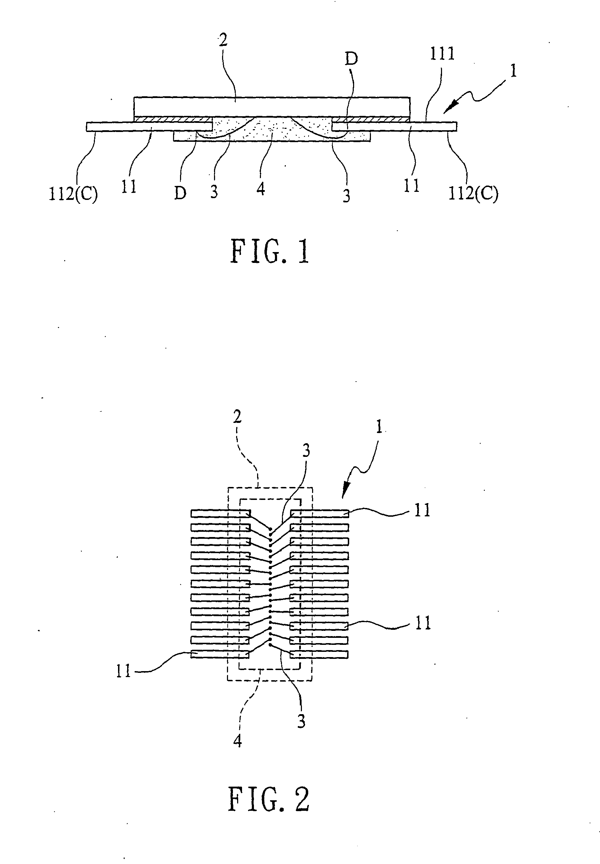

Furthermore , please refer to figure 1, the upper surface 111 of the multiple rectangular block leads 11 of leadframe 1 can carry together at least one chip 2, chip 2 is attached to the block leads 11 of leadframe 1 through adhesives (such as double side tape) .At least one metallic conducting wire 3 (wirebonding operation) is connected between the lower surface 112 of each lead 11 and chip 2, the leads 11 of leadframe 1 thus form as the electrically out-connecting part of chip 2; moreover, the surface of chip 2 which has metallic conducting wire connected to it is packaged with insulating material (such as thermo-setting plastic or ceramic) to form a miniaturized encapsulated body 4 enclosing metallic conducting wire 3 and two sides of connecting parts, (encapsulated body 4 is not limited to rectangular, round or other shapes), at least a conducting surface C on the lead lower part surface 112 which can be connected to outside is preserved, this forms a chip scale package structure of the current invention which is capable of reducing the packaged volume.

As the leadframe 1 disclosed in this invention containing a structure of leads 11 and encapsulated body 4, leads 11 is formed of rectangular block shape with metallic conducting wire 3 connecting part and a lower part surface 112 functioned as electrically out-connecting part (conducting surface C), any point on the conducting surface C can be used to be connected to other outside device, the distance between the connecting part D of metallic conducting wire 3 and conducting surface C is reduced and the electrical resistance of metallic lead 11 is in turn reduced, signal transfer speed then enhanced; furthermore, in this invention the encapsulated body applied on the leads where chip 2 is attached and the connecting part of metallic conducting wire 3 has achieved a protection and stabilization effect, it provides a way chip 2 can be connected to outside through leadframe 1, therefore the purpose of this local package structure through encapsulated body 4 is to reduce final package volume(package thickness and width, etc.), it also reduces package production-material cost while in the same time fits the miniaturized requirement of current electronic products ;moreover, in this invention the upper surface of chip 2 is not packaged ,encapsulated body 4 can be formed (filled with encapsulant) or not formed (not filled with encapsulant) on the side surfaces of leads 11, therefore , most surfaces of leads 11 are exposed and the inhibition of heat dissipation by encapsulant material seen in conventional package is thus prevented, chip 2 and leadframe 1 can thus have better heat dissipation .Especially when heat dissipating device such as heat sink is attached ,the heat generated by chip 2 can be released soon through such device ,it is thus obviously seen that this invention provides a structure with leads 11 and encapsulated body 4 which posses functions such as packaged volume reduction, high heat dissipation efficiency and higher transfer speed as well as the reduction of production cost.

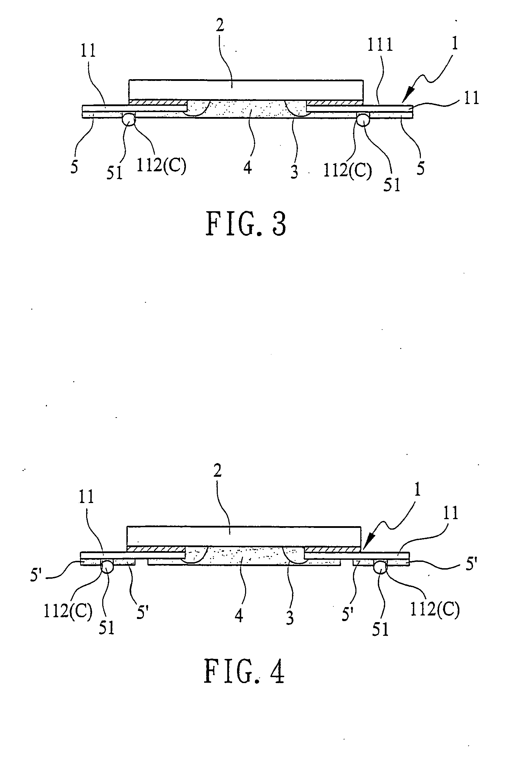

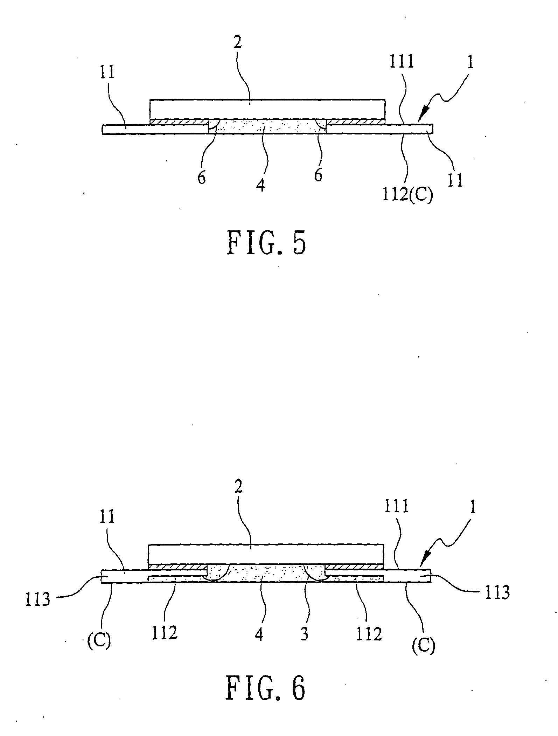

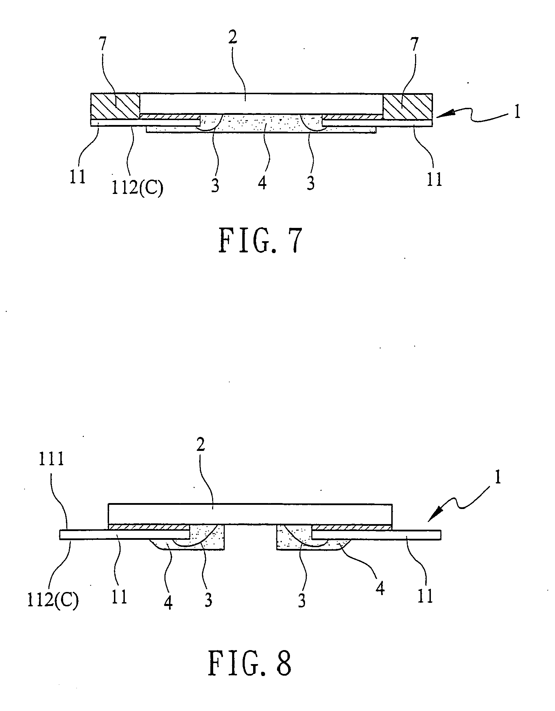

As previously described, this invention provides a local package structure which is located above leadframe1 and the part of chip 2 where it contains metallic conducting wire 3, a more practical package structure for transistor can thus be embodied based on the feature of this invention. As shown in figure 3, we can let the encapsulated body 4 of the local package structure protrudes through and below the lower surface of leadframe 1, a bump shape encapsulated body 5 is formed on the lower surface 112 of the side leads 11 of the encapsulated body 4, a slit like holding part 51 and conducting surface C of leads 11 are formed between encapsulated body 4 and 5 in order to provide an insertion part for electrically connecting object such as solder balls such that electrical connection can be formed when leadframe 1 is assembled onto other outside device. As shown in figure 4, two bump shape separated encapsulated bodies 5' can also be formed on the lower surface 112 of side leads 11 of encapsulated body 4, a slit like holding part 51' and leads 11 conducting surface C can be formed between two encapsulated bodies 5', it provides insertion part for electrically connecting object such as solder balls .It is further shown in figure 5, an electrically conducting connecting part 6 (such as solidified metallic solution or conducting plastic, etc.) can be used in between chip 2 and leads 11 for this invention to replace the above-mentioned connecting structure of metallic conducting wire 3, the connecting part 6 can be used to connect chip 2 and the sides of leads 11, connecting part 6 is thus hidden in the middle of leadframe 1 and the middle of leadframe 1 is locally packaged by encapsulated body 4, and the lower surface of encapsulated body 4 is set to be in the same plane as the bottom surface of leads 11 such that a thinner package structure can be fulfilled. Another embodiment of the current invention is as shown in figure 6, a lead structure can be selected with lower surface 112 containing a protruding part 113 where its adjacent lower surface 112 can be used as a connecting part for metallic conducting wire 3 and the lower part of protruding part 113 can be used as conducting surface for leads 11. Metallic conducting wire 3 is connected between the lower surface 112 and chip 2, the stair-like lower surface 112 is locally enclosed by encapsulated body 4, and let the lower surface of the encapsulated body 4 be in the same plane as the conducting surface C of the protruding part 113 of leads 11 to obtain effects such as encapsulation protection, thinner package structure, enhancement of transfer speed, enhancement of heat dissipation efficiency, etc. as mentioned above. Based on the above-mentioned embodiment of the current invention, a enclosure structure can be further formed on the peripherals of chips 2 with encapsulated body 7 (as shown in figure 7), a more stabilized package can be obtained and good heat dissipation property still be kept with this new package structure.

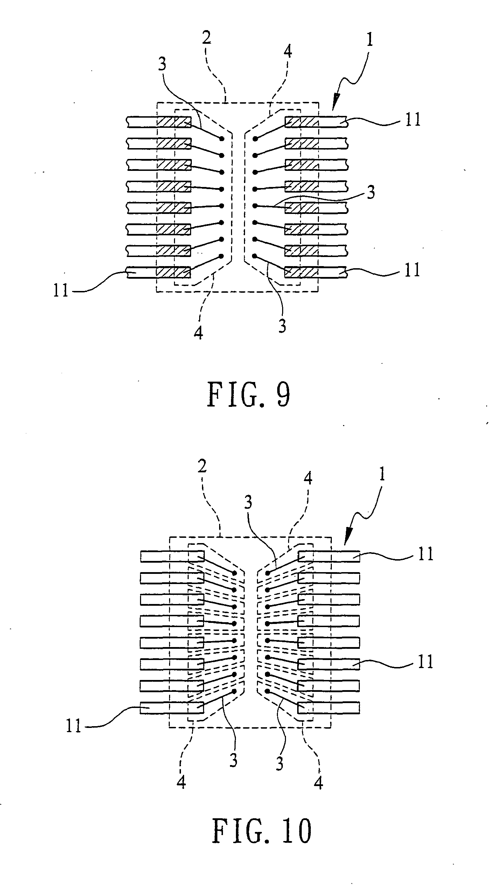

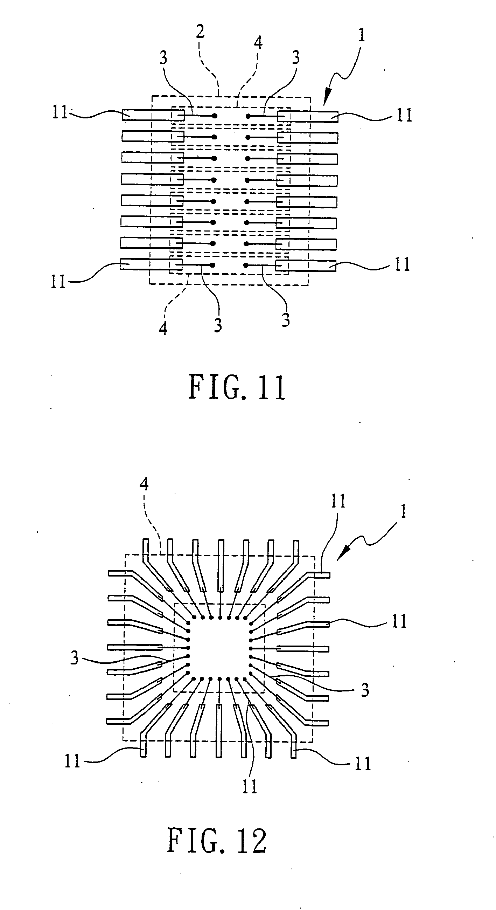

Furthermore, the above-mentioned structure of forming local package above metallic conducting wire 3 with encapsulated body 4 for the current invention could include the followings: as shown in figure 8 and 9, select a leadframe 1 with two rows of leads 11 and the metallic conducting wire part 3 of chip 2, encapsulated body 4 is formed on part of the leads 11 and metallic conducting wire 3 to form a block of encapsulated body 4, and two such blocks of encapsulated body 4 are formed on one side of chip 2. As further shown in figure 10, encapsulated body 4 can be applied separately on each lead 11 of leadframe 1 and the metallic conducting wire part 3 of chip 2 such that multiple point-like local package structures are formed on one side of chip 2. As further shown in figure 11 for another embodiment, encapsulated body 4 can be applied separately on the inner parts of each opposite pair of leads 11 of leadframe 1 and the metallic conducting wire part 3 of chip 2 such that the above-mentioned package functions can be reached. It is thus clear that the quantity and location of the encapsulated body 4 applied on one side of chip 2 can be varied according to actual production need, there is no limit; in the mean time, please refer to figure 12, we see this invention can be used for leadframe 1 with four rows or other number of rows of leads 11, and encapsulated body 4 structure with any kinds of arrangement according to the actual need as mentioned above can be applied above leads 11 and chip 2, for those skilled in the art, any simple modification or variation may be made therein without departing from the spirit of the invention or from the scope of the appended claims.

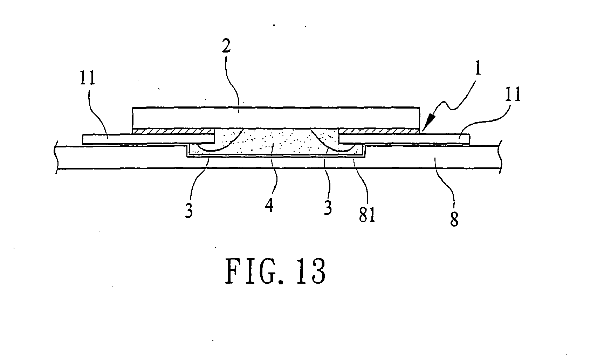

Yet another embodiment , the encapsulated body 4 for this invention can protrude a little bit below the lower surface of leadframe 11, when it is used together with other components such as printed circuit board 8 (as shown in figure 13) the encapsulated body 4 of the lower surface of leadframe 1 is accommodated by the open slot 81 formed on the surface of printed circuit board 8, the final assembled product thus have the advantages such as light weight, thin, and protection on the wire-bonding part.

Summarize the above descriptions, current invention of "miniaturized chip scale package structure" does possess the required properties of utility and invention, its embodiments are also inventive, we therefore submit a new type patent application.

## Claims

1. A miniaturized chip scale package structure comprising:
providing a leadframe containing multiple block leads forming a row type structure; a chip; and a leadframe with all leads connected to chip through metallic conducting wires, its main features are as below:
An area on the leadframe where its block leads are connected to the chip through metallic conducting wires is encapsulated with at least one encapsulated body, the encapsulated body forms local package on the metallic conducting wire and the connecting part, at least a conducting surface which is capable of being connected to outside is preserved on the lower surface of leads, a miniaturized chip scale package structure is thus formed.

2. The miniaturized chip scale package structure of claim 1 wherein said block leads of said leadframe forming a rectangular shape.

3. The miniaturized chip scale package structure of claim 1 wherein the lead conducting surface preserved by encapsulated body could include block leads with protruding part on the lower surface, the bottom surface of the protruding part is used as conducting surface.

4. The miniaturized chip scale package structure of claim 1 wherein other part of the leads lower part could be covered by other encapsulated body to form a slit-like insertion part where solder balls or electrically conducting part can be inserted into.

5. The miniaturized chip scale package structure of claim 1 wherein the encapsulated body thickness is such that its lower surface is in the same plane as the conducting surface of the leads.

6. The miniaturized chip scale package structure of claim 1 wherein said metallic conducting wire can be replaced by other conductive connecting material to connect chip and leads.

7. The miniaturized chip scale package structure of claim 1 wherein said chip is encapsulated on the peripherals.

8. The miniaturized chip scale package structure of claim 1 wherein the space between leads is encapsulated or is not encapsulated.
